# FASCICULE DE BREVET EUROPEEN

(11) **EP 1 493 083 B1**
(45) Date de publication et mention de la délivrance du brevet: **30.09.2009**
(21) Numéro de dépôt: 03740574.3
(22) Date de dépôt: 07.04.2003
(51) Int. Cl.: G06F 9/44, G06F 15/80, G06F 17/50

(54) **SYSTÈME RECONFIGURABLE DE CONTRÔLE BASÉ SUR LA MISE EN OEUVRE MATÉRIELLE DE GRAPHES DE PÉTRI**
UMKONFIGURIERBARES STEUERSYSTEM AUF DER BASIS EINER HARDWAREIMPLEMENTIERUNG VON PETRI-GRAPHEN
RECONFIGURABLE CONTROL SYSTEM BASED ON HARDWARE IMPLEMENTATION OF PETRI GRAPHS

(30) Priorité: 09.04.2002 FR 0204396
(43) Date de publication de la demande: 05.01.2005
(73) Titulaire: COMMISSARIAT A L'ENERGIE ATOMIQUE, 75015 Paris (FR)
(72) Inventeur: BLANC, Frédéric, F-78140 Velizy-Villacoublay (FR); COLLETTE, Thierry, F-91120 Palaiseau (FR)
(74) Mandataire: Poulin, Gérard
(86) Numéro de dépôt international: PCT/FR2003/001086
(87) Numéro de publication internationale: WO 2003/085522

(56) Documents cités:
- US-A- 4 068 214
- US-A- 4 700 187
- SKLYAROV V ET AL: "Design and implementation of control circuits based on dynamically reconfigurable FPGA" ELECTRONICS, CIRCUITS AND SYSTEMS, 1998 IEEE INTERNATIONAL CONFERENCE ON LISBOA, PORTUGAL 7-10 SEPT. 1998, PISCATAWAY, NJ, USA,IEEE, US, 7 septembre 1998 (1998-09-07), pages 527-530, XP010366138 ISBN: 0-7803-5008-1
- J. MORRIS: "A Re-configurable Processor for Petri Net Simulation" PROC. 33RD HAWAII INT. CONF. ON SYSTEM SCIENCES, 2000, pages 1-9, XP002226047 IEEE, New York, NY, USA
- VIITANEN J ET AL: "Mapping algorithms onto the TUT cellular array processor" APPLICATION SPECIFIC ARRAY PROCESSORS, 1990. PROCEEDINGS OF THE INTERNATIONAL CONFERENCE ON PRINCETON, NJ, USA 5-7 SEPT. 1990, LOS ALAMITOS, CA, USA,IEEE COMPUT. SOC, US, 5 septembre 1990 (1990-09-05), pages 235-246, XP010033949 ISBN: 0-8186-9089-5

## Description

### DOMAINE TECHNIQUE

La présente invention concerne un système reconfigurable basé sur la mise en oeuvre de graphes de Pétri.

### ETAT DE LA TECHNIQUE ANTERIEURE

Tout traitement pouvant être décomposé en deux parties, une partie contrôle qui permet de décrire l'ordonnancement des opérations à accomplir, et une partie opérative qui réalise ces opérations, est-par la suite appelée "application".

L'invention consiste à proposer un système pour la mise en oeuvre de la partie contrôle d'une application. Ce système est compatible avec les différents paradigmes de parallélisme (parallélisme de données, d'instructions ou de tâches), et peut être utilisé avec les différents type de calculateurs existants qu'ils soient synchrones ou asynchrones.

L'invention est basée sur l'utilisation de graphes de Pétri qui permettent de modéliser la partie contrôle des applications. Usuellement, ce type de modélisation est utilisé dans le domaine logiciel car elle permet d'effectuer la vérification formelle sur les applications comme décrit dans le document référencé [1] en fin de description. Les réseaux de Pétri sont aussi à la base de la programmation des automates et notamment des PLC ("programmable Logic Controler" ou "contrôleur logique programmable"), comme décrit dans le document référencé [2]. L'utilisation de cette modélisation pose un certain nombre de problèmes : notamment la taille de ces graphes augmente très rapidement avec la taille des applications. Les PLC sont généralement basés sur une solution logicielle associée à une unité de calcul classique.

Le document de référence [3] décrit un réseau logique asynchrone capable de mettre en oeuvre directement une spécification d'un système numérique par un graphe de Pétri.

L'invention, a pour objet un système permettant la transposition directe de graphes de Pétri sur un support Matériel.

### EXPOSÉ DE L'INVENTION

La présente invention décrit un système reconfigurable défini dans la présente revendication 1. Des modes préférentiels de réalisation de l'invention sont définis dans les revendications dépendantes.

Le système de l'invention est conçu en utilisant le concept de la reconfigurabilité qui permet de pouvoir changer dynamiquement, c'est-à-dire en cours de fonctionnement, le graphe de contrôle d'une application. La reconfigurabilité permet d'envisager une solution matérielle pour la gestion de ces graphes. En effet, il est possible avec un tel système de charger des graphes de Pétri par portion, ce qui ne limite pas la taille des applications pouvant être traitées.

### BRÈVE DESCRIPTION DES DESSINS

La figure 1 illustre les entrées/sorties d'une cellule état.
La figure 2 illustre les différents types de connexions entre cellules états.
La figure 3 illustre la transposition d'un graphe de Pétri.
La figure 4 illustre la transposition d'un graphe de Pétri utilisant la destruction de jetons.
La figure 5 illustre la synchronisation entre deux graphes de Pétri.
La figure 6a illustre un réseau entièrement connecté.
La figure 6b illustre un court-circuit qui permet d'utiliser la cellule état comme un connecteur.
La figure 6c illustre le nombre de connexions nécessaire qui est réduit par l'utilisation de connexions indirectes.
La figure 7 illustre un exemple de mise en oeuvre fonctionnelle de la cellule état, le jeton mémorisé étant détruit après sa transmission.
La figure 8 illustre un exemple de connexion entre deux cellules états existantes, avec :
   (a) marquage des cellules états source et destinataire,
   (b) recherche de la cellule état destinataire,
   (c) destruction des connexions inutiles.
La figure 9 illustre le séquencement des étapes de la connexion automatique entre deux cellules.
La figure 10 illustre l'alimentation en évènements d'un graphe de Pétri mis en oeuvre dans le système de l'invention.
La figure 11 illustre une structure de la mémoire associée aux graphes de Pétri mis en oeuvre dans le système de l'invention.
La figure 12 illustre la mise en oeuvre du système de l'invention pour un traitement SISD ("single instruction stream single data stream" ou "simple flot de données simple flot d'instructions").
La figure 13 illustre la mise en oeuvre du système de l'invention pour un traitement SIMD ("single instructions stream multiple data stream" ou "simple flot d'instructions multiple flot de données").
La figure 14 illustre la mise en oeuvre du système de l'invention pour un traitement MIMD ("multiple instructions stream multiple data stream" ou "multiple flot d'instructions multiple flot de données").
La figure 15 illustre un exemple d'une hiérarchie mémoire classique.
La figure 16 illustre un cache du type "2-way set-associative cache" ou "cache à deux ensemble associatifs",
La figure 17 illustre une accessibilité d'un état.

### EXPOSÉ DÉTAILLÉ DE MODES DE RÉALISATION PARTICULIERS

L'invention propose d'utiliser une représentation sous forme de graphes de Pétri pour modéliser une application. Les graphes de Pétri supportés par l'invention doivent répondre à trois critères :
- Il y a un seul jeton par place,
- Si deux jetons se rejoignent, il n'en forme plus qu'un,
- Un jeton peut être transmis vers plusieurs places.

Une application peut être modélisée par ces graphes de Pétri. En effet, chaque place du graphe de Pétri peut être liée à une action et la transition entre deux places est validée par des évènements de contrôle. Ces évènements de contrôle servent à faire progresser les jetons dans les graphes de Pétri mis en oeuvre dans le système de l'invention. Ils peuvent provenir de différents modules selon l'application à modéliser. A titre d'exemple, il peut s'agir des sorties d'un capteur ou des drapeaux d'événements d'une ALU (unité arithmétique et logique).

L'invention consiste donc en un système reconfigurable permettant la modélisation de graphes de Pétri : un ou plusieurs jetons vont circuler dans le système de l'invention en fonction d'évènements. Les places, qui reçoivent les jetons, déterminent les actions à accomplir.

Chaque place du réseau de Pétri correspond à une cellule de base du système de l'invention. Cette cellule, appelée par la suite "cellule état", peut :
- recevoir un jeton,
- être activée par l'arrivée d'un jeton,
- transmettre son jeton vers d'autres cellules états si elle a été activée par l'arrivé d'un signal de validation,
- détruire son jeton sans le transmettre par l'arrivée d'une demande de "reset" ou de mise à zéro.

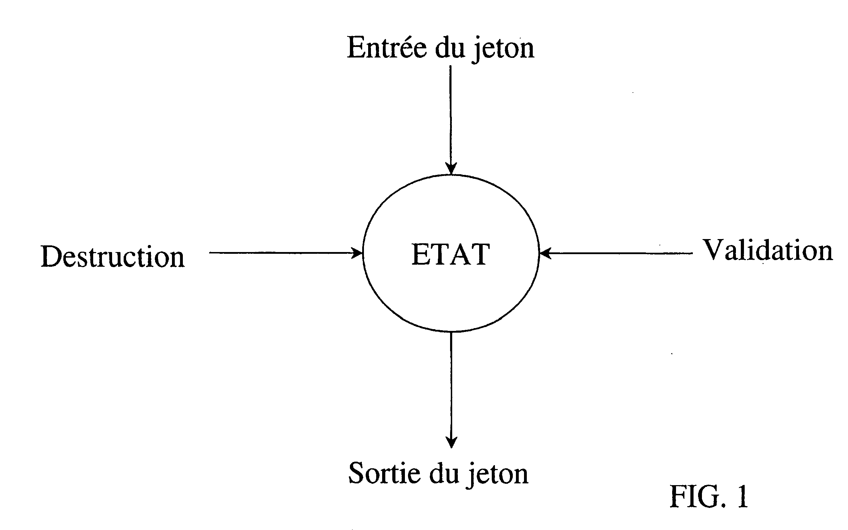

Chaque cellule état possède trois entrées, entrée du jeton, entrée de destruction et entrée de validation, et une sortie de jeton, comme illustré sur la figure 1.

Le jeton entre dans la cellule état où il est stocké. Si la validation est activée alors le jeton est transféré vers la sortie. Si la commande de destruction est activée, le jeton est supprimé de la cellule état et la validation n'a plus d'effet.

Ces cellules états sont dupliquées en très grand nombre et sont connectées les unes aux autres par un réseau reconfigurable de connecteurs. Trois types de connexions entre deux cellules états existent :
- Connexion de transmission : indique l'état (ou les états) suivant(s).
- Connexion de validation : permet de valider la transmission du jeton.
- Connexion de destruction : permet de détruire un jeton.

La reconfiguration consiste ici à relier les cellules états entre elles de façon à modéliser les graphes de Pétri associés à l'application.

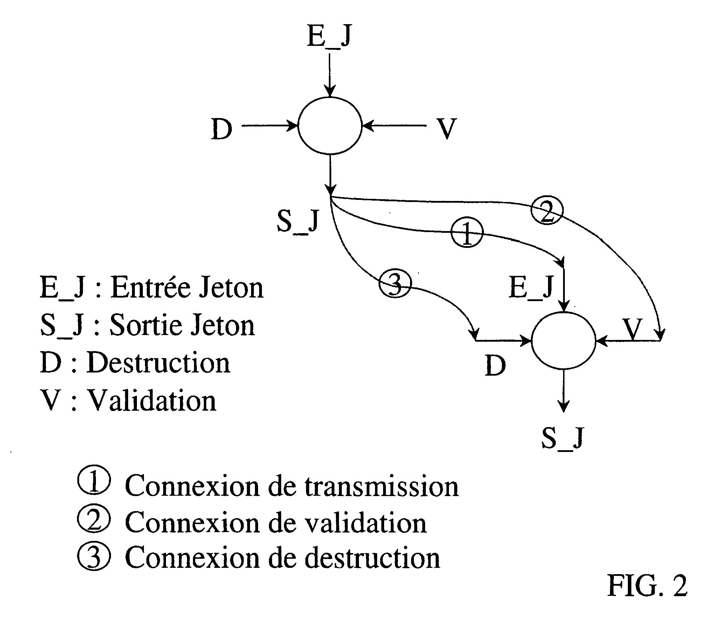

La figure 2 illustre les différents types de connexion :
1. une connexion de transmission,
2. une connexion de validation,
3. une connexion de destruction,
   avec E_J : entrée jeton
   S_J : sortie jeton
   D : destruction
   V : validation

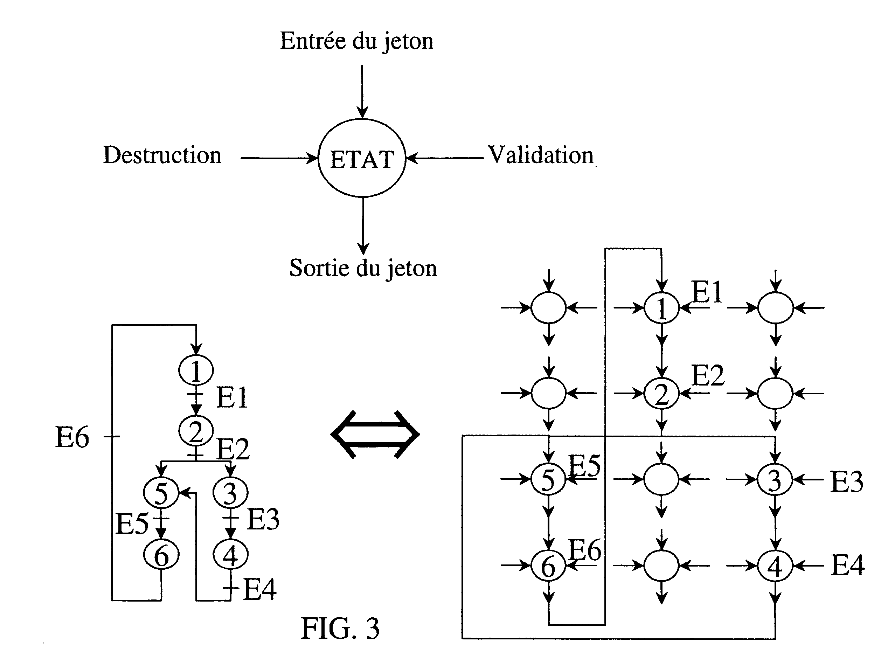

Trois exemples de transpositions de graphe de Pétri sont données respectivement dans les figures 3, 4 et 5.

La partie contrôle d'une application sert à réaliser les connexions entre les cellules états. L'invention propose d'utiliser une technologie reconfigurable afin de traduire la partie contrôle d'une application sous forme d'interconnexions.

Le premier exemple (figure 3) illustre une transposition simple entre un graphe de Pétri et sa mise en oeuvre en utilisant la cellule état. La transposition consiste dans ce cas à réaliser les chemins de transfert du jeton en connectant les cellules états entre elles (connexions de transmission).

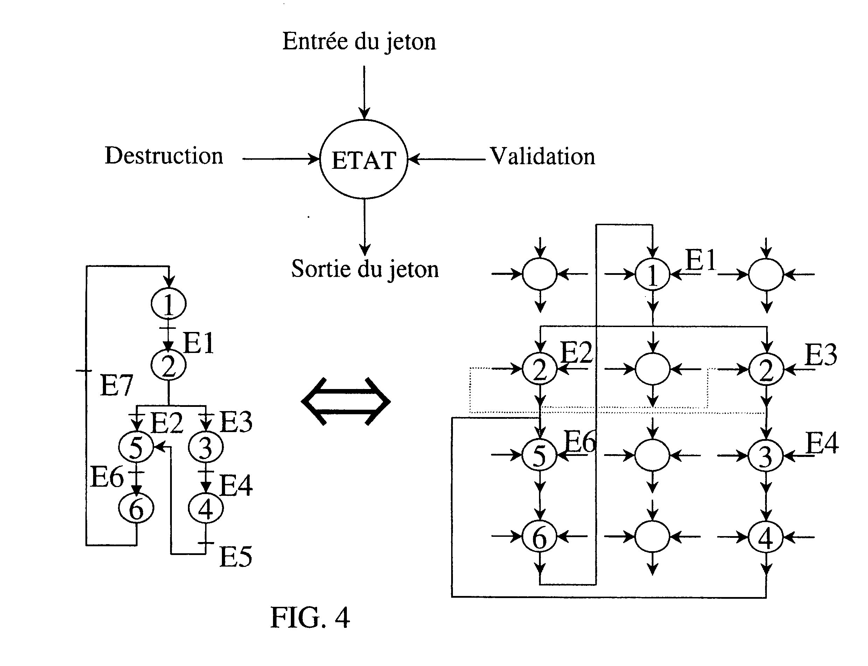

Le second exemple (figure 4) montre l'utilisation de connexions de destruction. Dans le graphe de Pétri (à gauche) si la cellule numéro 2 possède le jeton, deux évènements peuvent avoir lieu :
- E2 : dans ce cas le jeton est transmis à la cellule numéro 5.
- E3 : dans ce cas le jeton est transmis à la cellule numéro 3.

Le jeton ne peut pas être simultanément dans la cellule numéro 5 et dans la cellule numéro 3. Pour mettre en oeuvre ce graphe de Pétri, il est nécessaire d'utiliser les connexions de destruction. Dès qu'un des deux évènements (E2 ou E3) a lieu, le jeton en attente de l'autre évènement est détruit. Ainsi les cellules numéros 5 et 3 ne peuvent pas être validées en même temps.

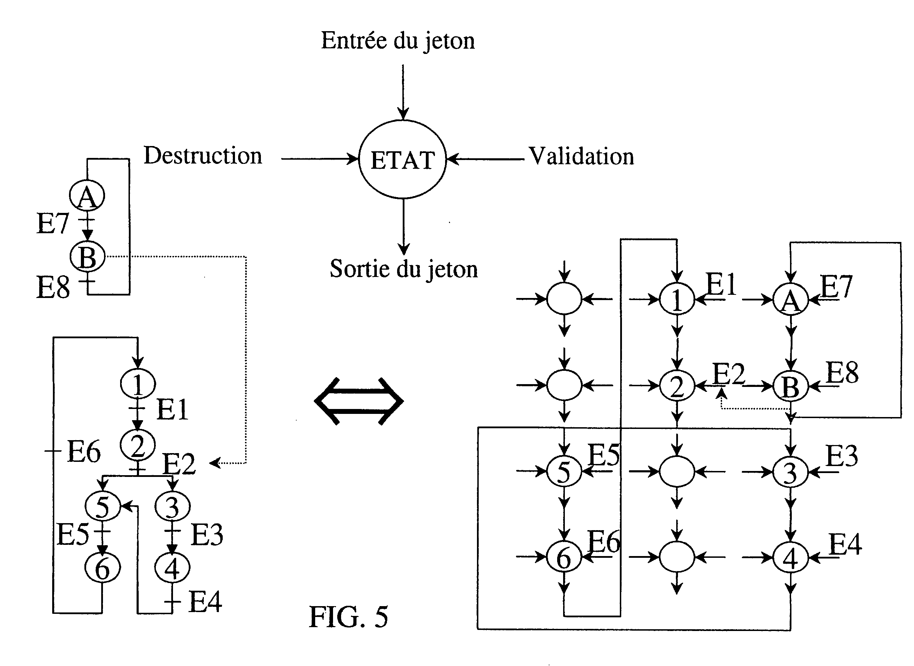

Dans le troisième exemple (figure 5), il y a deux graphes de Pétri à mettre en oeuvre et à synchroniser. La synchronisation est réalisée en utilisant les connexions de validation, c'est à dire que le passage du jeton dans la cellule numéro B sert à activer le passage du jeton de la cellule numéro 2 à la cellule(s) numéro(s) 5 ou/et 3.

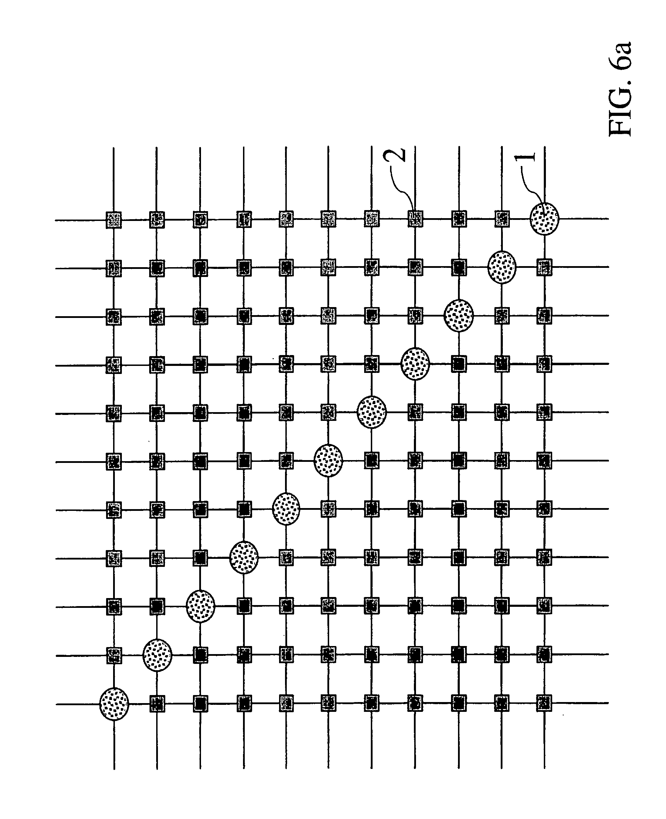

Afin de pouvoir réaliser n'importe quel graphe de Pétri, il faut que les cellules soient entièrement interconnectables : une cellule doit pouvoir se connecter avec toutes les autres. Si la structure possède N cellules états, il faut donc N² connecteurs 2 comme illustré sur la figure 6a.

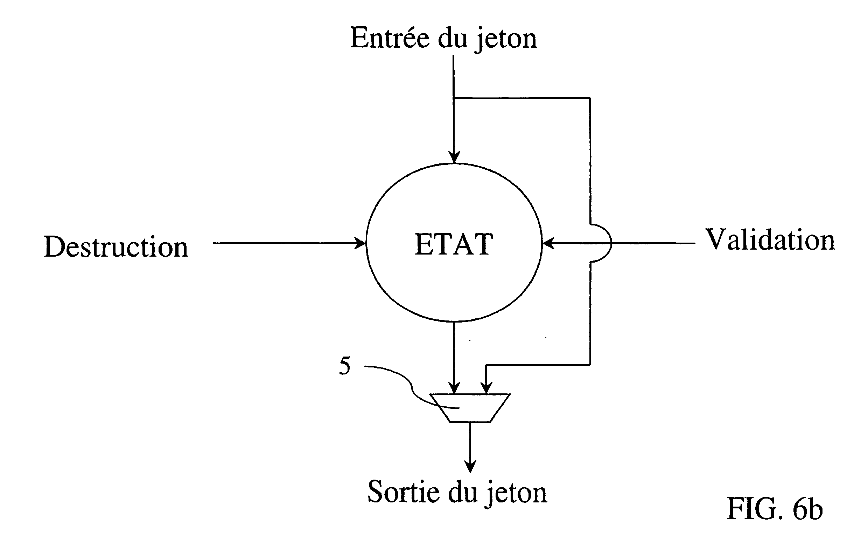

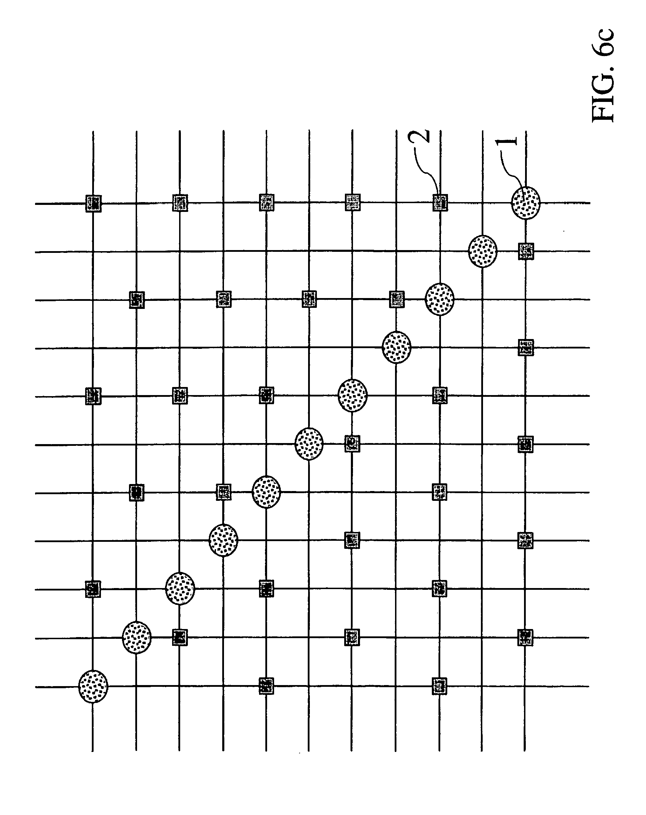

Pour limiter le nombre de connecteurs 2 nécessaires, un nouveau type de connexion est ajouté aux trois précédents. La cellule état est modifiée en réalisant une connexion entre l'entrée et la sortie du jeton au moyen d'un multiplexeur 5, comme illustré sur la figure 6b. Cette nouvelle connexion permet d'utiliser la cellule état comme un connecteur. Ce nouveau type de connexion est qualifié d'indirect et son utilisation permet de limiter le nombre de connecteurs nécessaires. En effet, chaque cellule 1 ne peut se connecter qu'à un nombre limité de cellules, mais chaque cellule peut servir de connecteur afin d'augmenter la connectivité du réseau comme illustré sur la figure 6c.

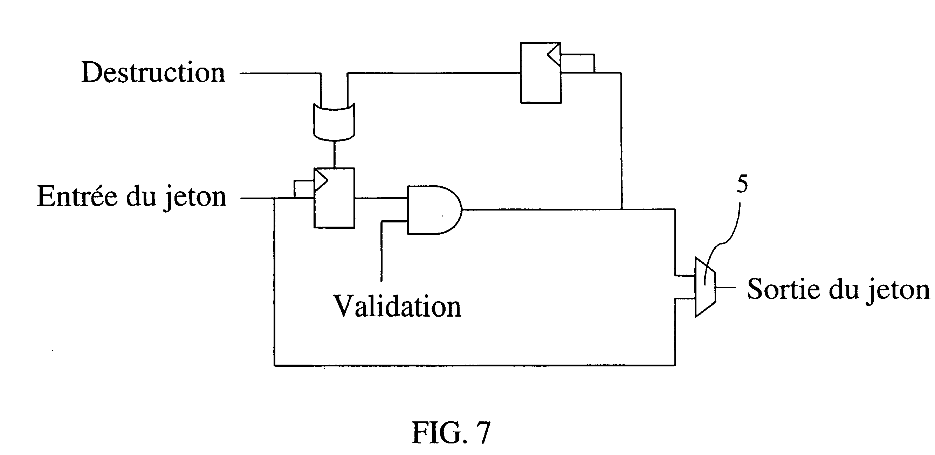

A titre d'exemple, la figure 7 montre une mise en oeuvre fonctionnelle d'une cellule état supportant les connexions indirectes.

Afin de faciliter la mise en oeuvre des graphes de Pétri, la réalisation des connexions entre les cellules états est automatisée. Pour ce faire, chaque cellule état peut accomplir des actions de base appelées "primitives". Quatre primitives permettent de construire facilement un graphe de Pétri :
- Choix de la connexion à réaliser.
- Réalisation d'une connexion vers une cellule état libre.
- Réalisation d'une connexion vers une cellule état utilisée.
- Libération (déconnexion) de la cellule état.

Toutes ces primitives peuvent être effectuées par chacune des cellules d'états. L'envoi des primitives est par contre géré par un dispositif de contrôle externe. Ce contrôleur est chargé de la gestion des cellules états. Il doit notamment gérer l'envoi des primitives vers les cellules afin de permettre la construction des graphes de Pétri. Il est aussi responsable de la libération des ressources en vue de l'utilisation de la structure du système de l'invention comme un cache mémoire (utilisation décrite par la suite).

Toutes les cellules états peuvent recevoir des instructions afin de connaître la primitive à effectuer. Si une cellule état n'est pas utilisé, elle est marquée comme libre sinon comme utilisée.

La première primitive consiste à transmettre à une cellule état le type de connexion qu'elle doit réaliser. Ainsi chaque cellule doit être en mesure de contenir une information relatant la connexion qu'elle doit réaliser. La cellule doit mémoriser le type de connexion qu'elle va devoir établir (connexion de transmission, de validation ou de destruction).

La seconde primitive consiste à se connecter à une nouvelle cellule état. La cellule état devant réaliser cette connexion cherche parmi les cellules états libres de son voisinage, c'est-à-dire celles auxquelles elle peut accéder de manière directe. Si une cellule libre est trouvée, la connexion est réalisée. Ceci impose que la cellule soit en mesure d'envoyer une requête de connexion vers chacune de ces voisines et de vérifier leur état de liberté. Ainsi, un signal de demande de connexion doit être envoyé vers les cellules voisines et chacune d'elles doit fournir un signal caractéristique de son état (libre ou utilisée).

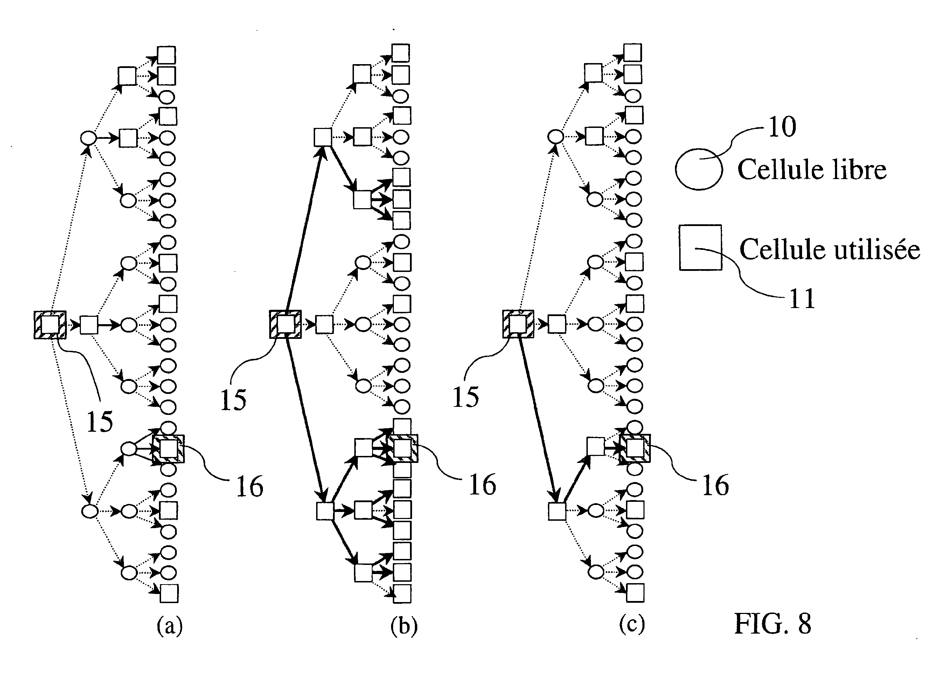

La troisième primitive consiste à réaliser automatiquement les connexions entre deux états. Cette primitive est réalisée en trois étapes successives comme illustré sur la figure 8, sur laquelle sont représentées notamment les cellules libres 10 et les cellules utilisées 11 :
1. Les deux cellules à connecter entre elles sont identifiées. La cellule état qui tente d'établir la connexion est appelée source 15, la seconde est qualifiée de destinataire 16. La cellule destinataire est marquée comme libre. Hormis la cellule source et la cellule destinataire, toutes les cellules réalisent des connexions indirectes (figure 8a).
2. Depuis la cellule état source, des connexions sont établies vers les cellules libres de son voisinage. Ce processus est répété depuis chacune des nouvelles cellules connectées jusqu'à ce que la cellule destinataire soit trouvée. Cette étape requière que chaque cellule puisse connecter toutes les cellules libres de son voisinage en leur imposant de réaliser la même opération (figure 8b).
3. Les connexions inutiles sont détruites. Il ne subsiste alors que la connexion désirée. Afin de permettre cette dernière étape, la cellule destinataire envoie un signal de validation. Toutes les cellules qui ne reçoivent pas ce signal peuvent alors être déconnectées. Il faut s'assurer que la cellule source a bien reçu le signal de la cellule destinataire avant de détruire les connexions inutiles de façon à bien identifier les cellules états à détruire. Il est donc nécessaire que les cellules connectées au cours de la réalisation de cette primitive puissent recevoir le signal de la cellule destinataire (figure 8c).

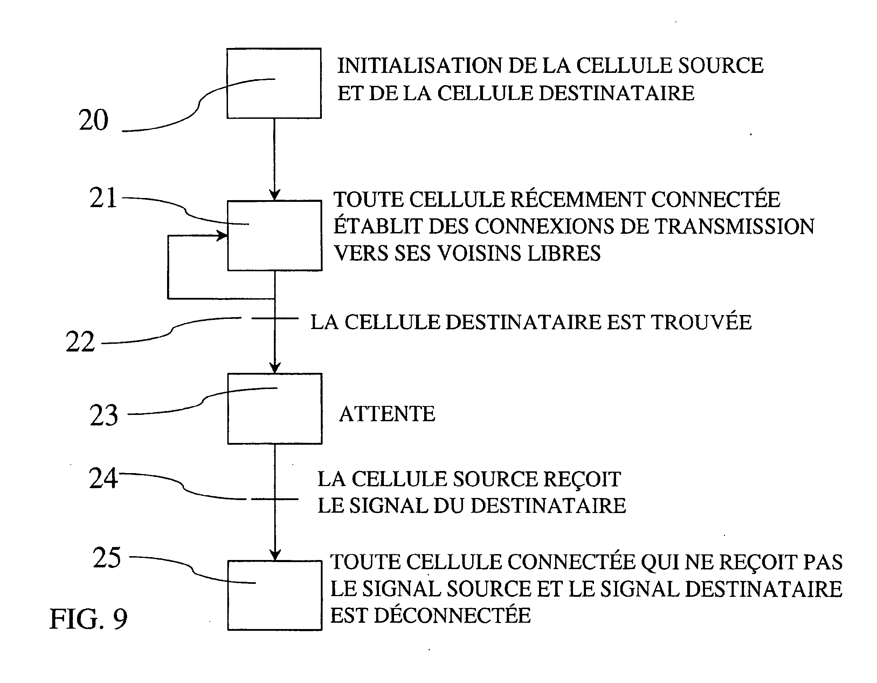

Chacune des étapes de la troisième primitive est réalisée par les cellules. Par contre le séquencement de ces étapes nécessite l'intervention du contrôleur externe évoqué précédemment. Le graphe de fonctionnement qui gère ce processus et qui devra être intégré au contrôleur externe est illustré sur la figure 9. Sur cette figure on a successivement :
- initialisation de la cellule source et de la cellule destinataire (20),
- établissement par toute cellule récemment connectée de connexions de transmission vers les cellules voisines libres, en commençant par la cellule source (21), jusqu'à l'obtention de la cellule destinataire (22),
- attente (23), jusqu'à la réception par la cellule source du signal de la cellule destinataire (24),
- déconnexion de toute cellule connectée qui ne reçoit pas le signal source et le signal destinataire (25).

La quatrième primitive est une sécurité qui permet d'éviter le blocage du système dû au manque de cellules libres. Elle autorise le forçage de la libération d'une cellule état en vue de sa réutilisation.

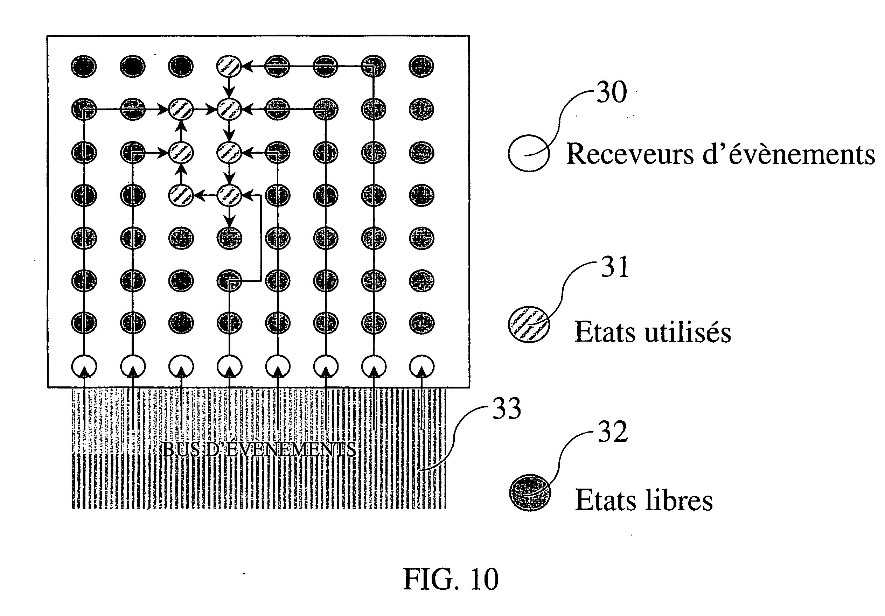

Afin d'alimenter le système de l'invention en évènements, comme illustré sur la figure 10, un mécanisme de récupération et de distribution d'évènements est mis en place. Certaines cellules ne sont pas connectables par les autres cellules états du système. Ces cellules reçoivent directement leurs jetons depuis un bus d'évènements 33 et sont appelées "receveurs d'événements". Le bus d'événements est constitué de l'ensemble des signaux qui sont associés à une transition dans les graphes de Pétri. Des connexions de validation peuvent être établies depuis ces cellules de façon à alimenter la structure en évènements. Les références 30, 31 et 32 représentent respectivement : un receveur d'événement, les cellules états utilisés et les cellules états libres.

A chaque place du graphe de Pétri correspond une action à accomplir. Il faut donc mettre en place un dispositif permettant de lier une action à une cellule état. Chaque cellule doit donc être en mesure de signaler à la structure intégrant le système de l'invention la présence du jeton. De la même façon, chaque cellule doit aussi signaler quand elle est utilisée pour modéliser une place du graphe de Pétri, de façon à permettre au système la mise en correspondance avec l'action appropriée.

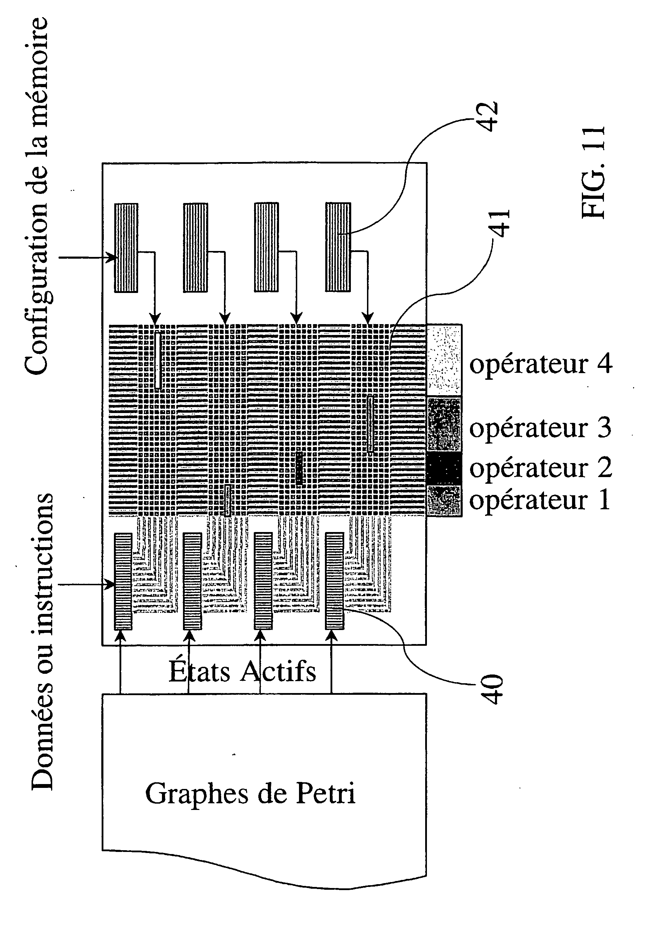

Une mise en oeuvre possible d'un tel mécanisme peut être basée sur l'utilisation d'une mémoire, comme illustré sur la figure 11. Afin de permettre la mise en relation entre la position d'un jeton et l'action correspondante, chaque cellule du système de l'invention est associée à une case mémoire 40. Ainsi à chaque fois qu'un jeton se déplace vers une nouvelle cellule, il active la lecture de la case mémoire associée à cette cellule. De même quand une cellule est connecté, il est alors possible de connaître la case mémoire où il faut placer l'information d'action correspondante. Il est ainsi possible d'envoyer simultanément des données ou des instructions vers des opérateurs différents (cf. opérateurs 1, 2, 3 et 4 sur la figure 11).

Cette mémoire possède un bus de donnée reconfigurable 41. En effet, chaque case mémoire peut choisir la partie du bus de donnée sur laquelle la donnée va transiter grâce à une information de configuration 42. Cette configuration associée à chaque case mémoire est un code binaire qui permet de spécifier la partie du bus de donnée utilisée pour les transferts. Ainsi, il est possible que plusieurs cases mémoires soient actives en même temps sans conflit.

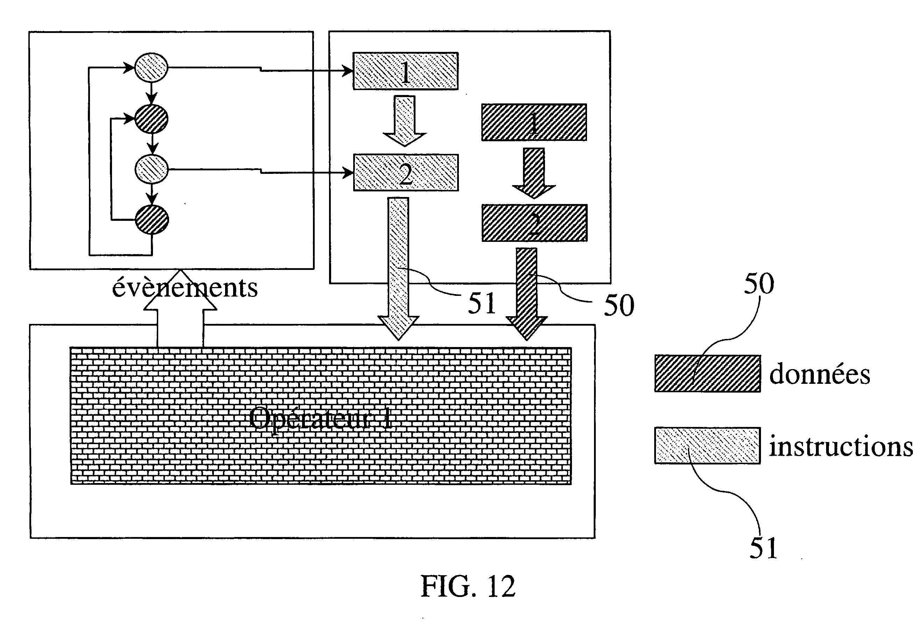

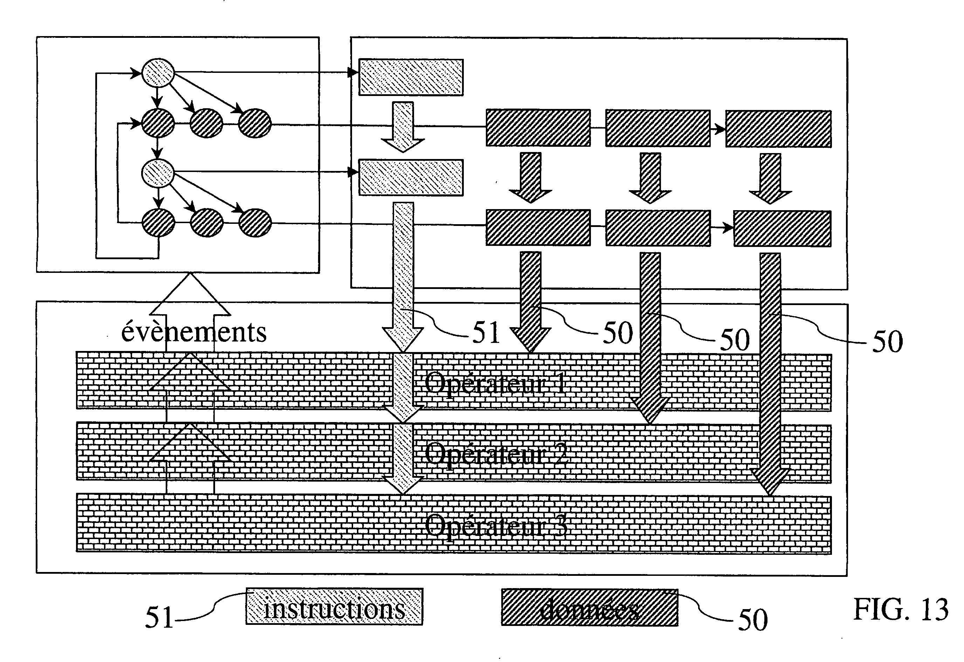

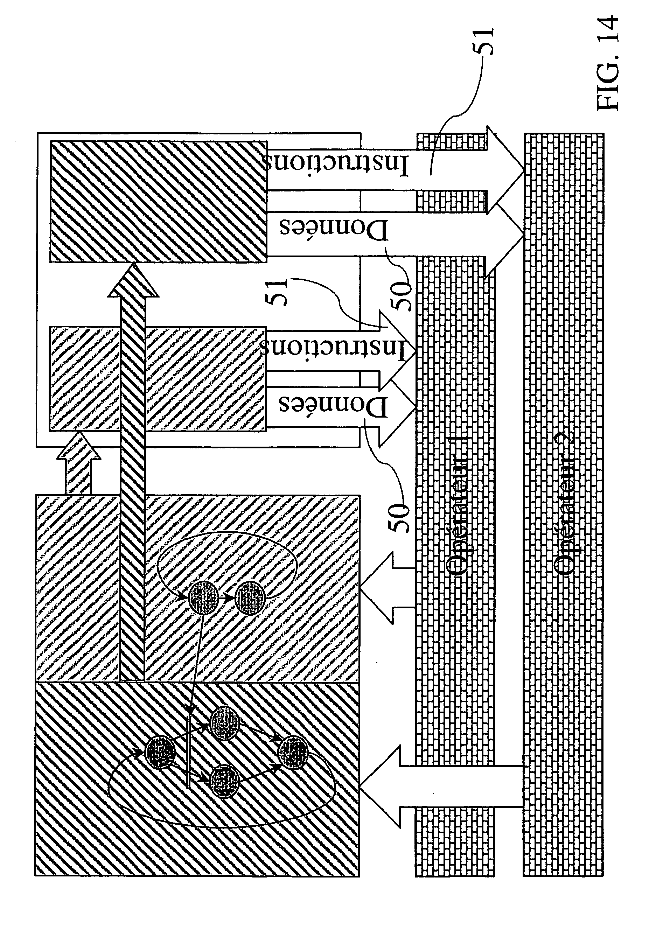

La structure de graphes de Pétri associée avec cette mémoire permet de gérer le contrôle de nombreuses architectures parallèles qu'elles soient synchrones ou non. Des exemples pour un traitement SISD, SIMD et MIMD, sont présentés respectivement dans les figures 12, 13 et 14, la représentation des données étant référencée 50, et celle des instructions 51.

Pour le traitement SISD deux flots sont générés par la propagation des jetons dans le graphe : un flot de données et un flot d'instructions. Ces deux flots sont envoyés vers un opérateur qui effectue le traitement en générant les évènements nécessaires au graphe de Pétri associé.

Pour le traitement SIMD, un flot d'instructions est généré et envoyé vers chacun des opérateurs, le graphe de Pétri étant "parallélisé" de façon à générer plusieurs flots de données qui serviront à alimenter les différents opérateurs de la structure SIMD ciblée.

Pour le traitement MIMD, des graphes de Pétri différents gèrent chacun des opérateurs, chacun de ces graphes permettant de générer les flots d'instructions et de données associés à chaque opérateur. Les graphes peuvent être synchronisés entre eux de manière à coordonner les opérateurs.

L'utilisation des graphes de Pétri permet d'éviter la mise en oeuvre d'un contrôleur destiné à la synchronisation des opérations lors d'un traitement SIMD ou MIMD. Le mode MIMD est obtenu par la possibilité de décrire et de parcourir plusieurs graphes en parallèles. Il est alors possible en utilisant la mémoire configurable décrite précédemment de générer des flots de données et d'instructions parallèles compatibles avec la structure MIMD ciblée.

Le chargement des graphes de Pétri sur la structure reconfigurable peut être dynamique. En effet, la progression des jetons dans les graphes n'est pas incompatible avec le chargement de graphes. Par exemple, pour des applications complexes l'ensemble du graphe ne peut pas tenir sur la structure. Le système fonctionne alors à la manière d'un cache : il garde en mémoire les actions à effectuer dans la suite de l'application. Le fonctionnement des caches ainsi que des exemples de mises en oeuvre classiques sont décrits dans la suite.

Afin de montrer les avantages apportés par la mise en oeuvre matérielle des graphes de Pétri, on va, à présent, considérer un état de l'art sur les caches. Le principe de fonctionnement de la hiérarchie mémoire de nombreux système est basé sur l'utilisation de caches. Ces caches dérivent du même schéma de base. Les différences entre les diverses architectures de hiérarchie mémoire reposent sur le nombre et la taille des caches utilisés ainsi que sur la gestion des données stockées. Le nombre de cache est compris entre 1 et 3 selon le système considéré. La taille des caches diminue quand on se rapproche du processeur ainsi les caches proches du processeur sont plus performant et possèdent des fréquences de fonctionnement compatibles avec les unités de calcul.

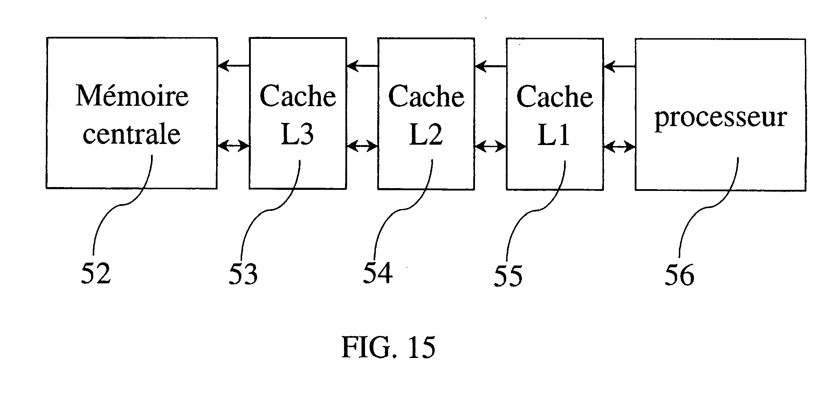

La figure 15 présente une hiérarchie mémoire à quatre niveaux qui part du processeur 56 jusqu'à la mémoire centrale 52 en passant par trois niveaux de cache L1 55, L2 54 et L3 53. La présence de la donnée ou de l'instruction est d'abord vérifiée dans la mémoire la plus proche du processeur. Si la donnée demandée n'est pas présente on descend dans la hiérarchie mémoire jusqu'à la trouver. Le mécanisme de chargement des données dans les caches permet de favoriser l'utilisation de la mémoire la plus proche du processeur (cache L1). Actuellement certaines architectures de processeur intègrent L1 et L2.

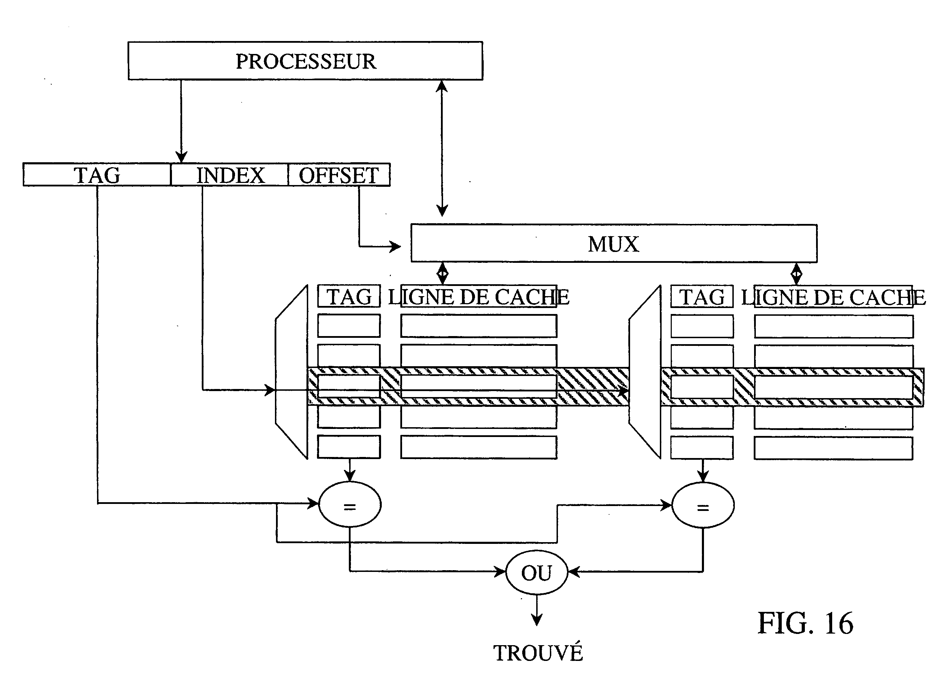

Le cache consiste en une mémoire qui contient une sous-partie de la mémoire centrale. L'adressage de cette.mémoire est réalisée par une sous-partie de l'adresse complète. La partie non utilisée de l'adresse sert à vérifier la validité de la donnée en mémoire. En effet la mémoire contient la donnée cachée ainsi qu'une clé permettant de reconstruire l'adresse complète de la donnée en mémoire centrale. La comparaison des deux clés va donc permettre de savoir si la donnée est valide ou non. Le mécanisme permettant d'associer une adresse absolue à une adresse de cache n'est pas une fonction bijective. C'est-à-dire qu'à une adresse de cache peut correspondre plusieurs adresses absolues qui sont qualifiées de concurrentes. Il existe deux grandes familles de cache :
- les caches de type "direct-mapped cache"
ou "cache direct" : dans ce cas la mémoire de cache est un sous-ensemble direct de la mémoire centrale. Ce type de cache est limité car il ne gère pas les adresses concurrentes.
- les caches de type "N-way sent-associative cache" ou "cache à N ensembles associatifs" : dans ce type de mémoire il y a N mémoires qui cohabitent ce qui permet de stocker plusieurs adresses concurrentes comme illustré sur la figure 16. Le cache de type "direct-mapped cache" est équivalent au cas où N est égale à 1.

Cette hiérarchie mémoire pose un certain nombre de problèmes :
- toutes les données stockées ne sont pas forcement utilisées,
- rallongement du temps d'accès mémoire,
- problème de cohérence entre les différentes mémoires,
- synchronisation obligatoire,
- accès séquentiels aux données,
   La mise en oeuvre directe des graphes de Pétri permet de résoudre certains de ces problème :
- Toutes les données stockées sont pertinentes et ont une probabilité d'être utilisées.
- L'accès mémoire n'est pas forcement séquentiel. Plusieurs données peuvent être accédées en même temps.
- La structure peut être utilisée par des systèmes synchrones ou asynchrones. La structure peut même être sollicitée par des systèmes n'ayant pas les mêmes mécanismes de synchronisation.

Le système de l'invention peut être utilisé dans la mise en oeuvre de caches. Le graphe de Pétri associé à une application pouvant être trop volumineux pour être intégré sur le système, il est nécessaire de la découper en parties. La partie du graphe de Pétri stockée sur le système doit donc être dynamiquement remise à jour en fonction de l'avancement de l'application. Certaines cellules états peuvent au cours de l'exécution de l'application ne plus être atteignables, cela signifie que ces cellules états ne peuvent plus recevoir de jetons. Chaque cellule état connaît en permanence si elle est atteignable ou non. Un dispositif capable de supprimer les cellules états non-atteignables est donc mis en place de façon à libérer certaines cellules états pour permettre le chargement de la suite du graphe. Ce dispositif doit permettre d'équilibrer le chargement et le déchargement des cellules états. Ce mécanisme est à intégrer dans le contrôleur externe introduit lors de la définition des primitives de la cellule état. Le déchargement des cellules états est réalisé en utilisant la primitive de libération présentée précédemment. Le contrôleur décide de la libération d'une cellule état en se basant sur son atteignabilité et sur un critère reflétant l'équilibre entre le chargement et le déchargement des cellules états. La libération de la cellule état est réalisée par l'utilisation de la primitive de libération. Il peut par exemple être mis en oeuvre de manière à maintenir constant le rapport entre les cellules états libres et les cellules états utilisées, ceci dans le but de maintenir des ressources de routage suffisantes.

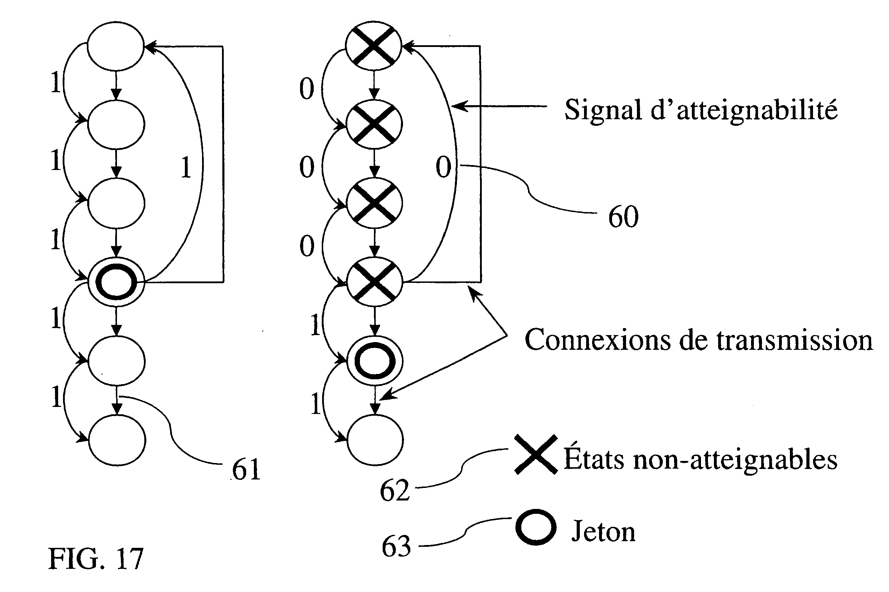

Chaque connexion de transmission de jeton est couplée avec une connexion qui permet de connaître si une cellule état est accessible ou non. En effet l'information qui circule sur ces connexions reflète la présence ou l'absence d'un jeton en amont de la cellule état considérée. S'il y a un jeton en amont de la cellule état il est atteignable, dans le cas contraire la cellule état sera considérée comme non-atteignable. La figure 17 illustre un tel mécanisme. Sur cette figure sont représenté le signal d'atteignabilité 60, les connexions de transmission 61, les états non atteignables 62, et le jeton 63.

### REFERENCES

[1] "Petri net theory and the modelling of systems" de James L. Peterson (1981, Practice Hall, ISBN: 0136619835).
[2] "Introduction to programmable logic controllers" " de Gary Dunning (deuxième édition, 1998, Delmas, ISBN: 0827378661).
[3] Brevet US-A-4 068 214.

## Revendications

1. Système reconfigurable pour la mise en oeuvre matérielle de la partie contrôle d'une application comprenant une partie contrôle et une partie opérative, ladite partie contrôle donnant l'ordonnancement des opérations à accomplir par la partie opérative, **caractérisé en ce qu'**il comprend :
- un ensemble de N cellules états matérielles entièrement interconnectables, N étant un entier supérieur à 1, chaque cellule correspondant à une place du graphe de Pétri associé à ladite application, pouvant se connecter à toutes les autres cellules et pouvant contenir ou non un jeton, chaque cellule possédant en outre une entrée du jeton, une entrée de destruction de jeton, une sortie de jeton et une entrée de validation, chaque cellule étant adaptée à stocker tout jeton reçu sur son entrée du jeton, à détruire son jeton sans le transmettre suite à l'activation de son entrée de destruction de jeton et à transmettre son jeton vers toute autre cellule connectée à ladite sortie de jeton, suite à l'activation de son entrée de validation ;
- un réseau reconfigurable de connecteurs permettant de relier lesdites cellules entre elles, la sortie de jeton d'une cellule pouvant être reliée à l'entrée de jeton d'une autre cellule par une première connexion, dite connexion de transmission, à l'entrée de validation de cette autre cellule par une seconde connexion, dite connexion de validation, et à l'entrée de destruction de cette autre cellule par une troisième connexion, dite connexion de destruction.

2. Système selon la revendication 1, dans lequel un multiplexeur (5) réalise une connexion entre l'entrée du jeton et la sortie: de jeton dans chaque cellule état, permettant d'utiliser la cellule état comme un connecteur.

3. Système selon la revendication 1, dans lequel chaque cellule état est apte à mettre en oeuvre toutes les primitives de construction du graphe de Pétri suivantes
- choix de la connexion à réaliser,
- réalisation d'une connexion vers une cellule état libre,
- réalisation d'une connexion vers une cellule état utilisée,
- déconnexion de la cellule état, la réalisation des connexions entre les cellules états étant automatisée.

4. Système selon la revendication 1, comprenant des cellules receveurs d'évènements (30) connectés à recevoir leurs jetons directement d'un bus d'évènements (33), ces cellules receveurs d'évènements (30) n'étant pas connectables par les autres cellules états du système.

5. Système selon la revendication 1, dans lequel chaque cellule état est associée à une case mémoire (40) d'une mémoire qui possède un bus de données reconfigurable.

6. Système selon l'une quelconque des revendications précédentes, dans lequel chaque cellule état est apte à connaître en permanence si elle est atteignable ou non.

## Claims

1. Reconfigurable system for physically implementing the control part of an application comprising a control part and an operative part, said control part scheduling the operations to be carried out by the operative part, **characterised in that** it comprises:
- a set of N physical state cells which are completely interconnectable, N being an integer greater than 1, each cell corresponding to a place on the Petri graph associated with said application, being able to connect to all the other cells and optionally containing a token, each cell also having a token input, a token destruction input, a token output and a validation input, each cell being programmed to store any token received at its token input, to destroy its token without transmitting it once its token destruction input has been activated and to transmit its token to any other cell connected to said token output once its validation input has been activated;
- a reconfigurable network of connectors able to interconnect said cells, the token output of a cell being connectable to the token input of another cell via a first connection called a transfer connection, to the validation input of said other cell via a second connection called a validation connection, and to the destruction input of said other cell via a third connection called a destruction connection.

2. System according to claim 1, wherein a multiplexer (5) connects the token input and the token output in each state cell, thus making it possible to use the state cell as a connector.

3. System according to claim 1, wherein each state cell is able to implement all the following primitives in order to construct a Petri graph:
- choice of the connection to be made,
- connection to a free state cell,
- connection to a used state cell,
- disconnection from the state cell,
the connections between the state cells being made in an automated manner.

4. System according to claim 1, comprising event receiver cells (30) connected so as to receive their tokens directly from an event bus (33), said event receiver cells (30) not being connectable via the other state cells of the system.

5. System according to claim 1, wherein each state cell is connected to a memory cache (40) of a memory which has a reconfigurable data bus.

6. System according to any one of the preceding claims, wherein each state cell is able to permanently recognise whether it is accessible or inaccessible.

## Patentansprüche

1. Rekonfigurierbares System für die materialisierte Verwendung des Steuerteils einer Anwendung, die einen Steuerteil und einen operativen Teil umfaßt, wobei der Steuerteil die Anweisung für Operationen gibt, die vom operativen Teil auszuführen sind, **dadurch gekennzeichnet, dass** es umfaßt:
- eine Gruppe von N materialisierten Zustandszellen, die untereinander vollständig verbindbar sind, wobei N eine ganze Zahl größer als 1 ist,
wobei jede Zelle einem Platz des Petrigraphen entspricht, der der Anwendung zugeordnet ist, sich mit allen anderen Zellen verbinden und wohl oder nicht ein Token enthalten kann, wobei jede Zelle ferner einen Tokeneingang, einen Tokenlöschungseingang, einen Tokenausgang und einen Validierungseingang besitzt, wobei jede Zelle dazu ausgelegt ist, jedes an ihrem Tokeneingang empfangene Token zu speichern, ihr Token infolge einer Aktivierung ihres Tokenlöschungseingangs zu löschen, ohne es zu übertragen, und ihr Token infolge einer Aktivierung ihres Validierungseingangs zu jeder anderen Zelle hin zu übertragen, die mit dem Tokenausgang verbunden ist;
- ein rekonfigurierbares Netz von Verbindern, die es ermöglichen, die Zellen miteinander zu verbinden, wobei der Tokenausgang einer Zelle mit dem Tokeneingang einer anderen Zelle mittels eines ersten Anschlusses verbunden werden kann, genannt Übertragungsanschluß, mit dem Validierungseingang dieser anderen Zelle mittels eines zweiten Anschlusses, genannt Validierungsanschluß, und mit dem Löschungseingang dieser anderen Zelle mittels eines dritten Anschlusses, genannt Löschungsanschluß.

2. System nach Anspruch 1, bei dem ein Multiplexer (5) einen Anschluß zwischen dem Tokeneingang und dem Tokenausgang in jeder Zustandszelle realisiert, was die Verwendung der Zustandszelle als Verbinder erlaubt.

3. System nach Anspruch 1, bei dem jede Zustandszelle dazu ausgelegt ist, alle nachfolgenden Konstruktionsgrundlagen des Petrigraphen zu verwenden:
- Wahl des zu realisierenden Anschlusses,
- Realisierung eines Anschlusses an eine freie Zustandszelle,
- Realisierung eines Anschlusses an eine verwendete Zustandszelle,
- Trennen der Anschlüsse der Zustandszelle,
wobei die Realisierung der Anschlüsse zwischen den Zustandszellen automatisiert ist.

4. System nach Anspruch 1, umfassend Ereignisempfängerzellen (30), die so angeschlossen sind, dass sie ihre Tokens direkt von einem Ereignisbus (33) empfangen, wobei diese Ereignisempfängerzellen (30) nicht mittels der anderen Zustandszellen des Systems anschließbar sind.

5. System nach Anspruch 1, bei dem jede Zustandszelle einem Speicherplatz (40) eines Speichers zugeordnet ist, der einen rekonfigurierbaren Datenbus besitzt.

6. System nach einem der vorhergehenden Ansprüche, bei dem jede Zustandszelle dazu ausgelegt ist, ständig zu wissen, ob sie erreichbar ist oder nicht.
